# EUROPÄISCHE PATENTSCHRIFT

(11) **EP 2 693 466 B1**
(45) Veröffentlichungstag und Bekanntmachung des Hinweises auf die Patenterteilung: **14.12.2016**
(21) Anmeldenummer: 13003760.9
(22) Anmeldetag: 29.07.2013
(51) Int. Cl.: H01L 21/67, C23C 16/448, B23Q 3/18

(54) **Vorrichtung zum Temperieren eines Gefäßes in einer Kammer**
Device for tempering a vessel in a chamber
Dispositif de régulation de la température d'un récipient dans une chambre

(30) Priorität: 31.07.2012 DE 102012015045
(43) Veröffentlichungstag der Anmeldung: 05.02.2014
(73) Patentinhaber: Dockweiler AG, 19306 Neustadt-Glewe (DE)
(72) Erfinder: Fiebig, Klaus-Dieter, DE - 21465 Reinbek (DE)
(74) Vertreter: Hauck Patentanwaltspartnerschaft mbB

(56) Entgegenhaltungen:
- EP-A1- 0 160 779
- WO-A1-2004/096427
- WO-A2-2006/099619
- DE-A1- 1 750 549

## Beschreibung

Die vorliegende Erfindung betrifft eine Vorrichtung zum Temperieren eines Gefäßes in einer Kammer.

Es besteht das Bedürfnis, Gefäße, in denen chemische Medien miteinander reagieren, nach Möglichkeit genau zu temperieren. So ist beispielsweise für chemische Bedampfungsverfahren und/oder bei der Dotierung von Halbleitern es bekannt, ein Gefäß, auch als Bubbler bezeichnet, in dem ein Dotiergas entsteht, in einer Temperiervorrichtung sehr genau zu temperieren. Hierzu ist das Gefäß in der Temperiervorrichtung angeordnet und nach außen abgedichtet. Da Bubbler in ihrem Umfangsdurchmesser Toleranzen und beispielsweise durch Schweißnähte verursachte Unregelmäßigkeiten besitzen, kann die Abdichtung in der Temperiervorrichtung beeinträchtigt sein. Die Temperiervorrichtung ist gut isoliert und wird über ein Medium, wie beispielsweise Wasser oder andere Temperiermedien, in seiner Kammer temperiert.

Aus der Auslegeschrift DE 1 750 549 ist ein Deckelverschluss für einen Druckbehälter bekannt, der eine L-förmige Lippendichtung aufweist, die mit einem Schenkel in einer ringförmigen Ausnehmung der Innenfläche des am Behälter befestigten Deckels angeordnet ist. Eine Dichtungslippe liegt an einer Innenfläche einer flachen Ringnut des Deckelverschlusses an.

Aus der Patentschrift DE 62 43 96 PS ist eine Verschlusseinrichtung für unter Überdruck arbeitende Sterilisationsapparate bekannt. Hierbei ist ein in einem umlaufenden Deckelflansch angeordnetes Dichtmittel über Klemmschrauben auf eine vorstehende Dichtkante gepresst.

Aus DE 20 2004 010 834 U1 ist eine Vorrichtung zum Temperieren eines Gutes in einer zylindrischen Kammer bekannt geworden, bei der über eine Vorrichtung von Schlitzen das zu temperierende Gut ringförmig mit temperierter Luft umspült wird.

Aus WO 2006/099619 A2 ist eine Vorrichtung zum Temperieren eines Gefäßes in einer Kammer bekannt, bei der zur Abdichtung des in die Kammer eingesetzten Gefäßes ein O-Ring um das Gefäß in einer umlaufenden Ausnehmung angeordnet und durch ein ringförmiges Klemmelement abgedichtet ist.

Der Erfindung liegt die Aufgabe zugrunde, eine Vorrichtung zum Temperieren eines Gefäßes in einer Kammer bereitzustellen, die mit einfachen Mitteln eine zweckmäßige und wirkungsvolle Abdichtung der Kammer im Inneren der Vorrichtung gestattet.

Erfindungsgemäß wird die Aufgabe durch eine Vorrichtung mit den Merkmalen aus Anspruch 1 gelöst. Vorteilhafte Ausgestaltungen bilden die Gegenstände der Unteransprüche.

Die erfindungsgemäße Vorrichtung ist dazu vorgesehen und bestimmt, ein Gefäß, insbesondere einen Bubbler, in einer Kammer zu temperieren. Die Vorrichtung besitzt einen zylindrischen Mantel, der die Kammer umschließt. Ferner ist ein Boden vorgesehen, der an einem Ende des Mantels angeordnet und mit diesem verbunden ist. Des Weiteren befindet sich an dem dem Boden gegenüberliegenden Ende eine Öffnung mit einer parallel zum Boden verlaufenden Anlagefläche, die den Durchmesser der Öffnung gegenüber dem Innendurchmesser der Kammer begrenzt. Das zu temperierende Gefäß wird über die Öffnung in die Kammer gesetzt. Erfindungsgemäß ist ein ringförmiges Dichtelement vorgesehen, das einen L-förmigen Querschnitt mit einem Dichtschenkel und einem Anlageschenkel aufweist, wobei der Anlageschenkel auf der Anlagefläche aufliegt. Zusätzlich ist ein ringförmiges Spannelement vorgesehen, das, auf das Dichtelement aufgesetzt, an dem Dichtschenkel auf dessen Außenseite anliegt. Durch ein Einstellen des Spannelements kann der Dichtschenkel mit seiner Innenseite gegen die Außenseite des Gefäßes verspannt und so die Kammer dichtend abgeschlossen werden. Der Vorteil, an einem ringförmigen Dichtelement, das zwei

Schenkel besitzt, besteht darin, dass zum Einsetzen und Entnehmen des Gefäßes aus der Kammer die Dichtung entfernt werden kann und so das Gefäß besonders leicht in der Kammer angeordnet und aus dieser entfernt werden kann. Zudem können durch das Spannelement unterschiedliche Außenmesser des Gefäßes ausgeglichen werden. Auch kann die gesamte Vorrichtung durch die Wahl eines geeigneten Dichtelements und des geeigneten Spannelements für Gefäße mit unterschiedlichem Durchmesser verwendet werden. Durch die erfindungsgemäße Dichtung über ein verspanntes Dichtelement wird zudem die Möglichkeit geschaffen, die Temperiervorrichtung mit Überdruck zu betreiben, also ein unter Druck stehendes Temperiermedium in den Zwischenraum zwischen Gefäß und Innenseite der Kammerwand einzubringen.

In einer bevorzugten Ausgestaltung weist die Vorrichtung ferner Verbindungsmittel auf, mit denen der Anlageschenkel an der Anlagefläche befestigbar ist. Zweckmäßigerweise weist der Anlageschenkel der Dichtung Bohrungen für die Verbindungsmittel auf. Über die Verbindungsmittel, die zusätzlich zu dem Spannelement, das Dichtelement an der Vorrichtung festlegen, kann das Dichtelement in axialer Richtung, bezogen auf die Längsrichtung der Kammer auf der Anlagefläche festgelegt werden. Bevorzugt sind als Verbindungsmittel eine Anpressplatte und Schrauben vorgesehen, die auf dem Anlageschenkel des Dichtelements aufgelegt und mit den Schrauben durch das Dichtelement hindurch befestigt sind. Alternativ oder zusätzlich kann eine Schnellspanneinrichtung vorgesehen sein, die beispielsweise über einen Kniehebelmechanismus den Anlageschenkel oder einen auf diesem angeordneten Anpressring gegen die Anlagefläche der Temperiervorrichtung presst.

In einer bevorzugten Ausgestaltung ist das Dichtelement als umlaufender Ring ausgebildet, an dem Dichtschenkel und Anlageschenkel im Wesentlichen senkrecht zueinander stehen.

In einer bevorzugten Ausgestaltung ist das Dichtelement derart dimensioniert, dass es radial einwärts die Anlagefläche überragt. Auf diese Art und Weise ist das Dichtelement in radialer Richtung besonders elastisch und kann sich an unterschiedliche Durchmesser des Gefäßes anpassen. Die Dichtung der Kammer erfolgt dann durch die an dem Gefäß anliegende Innenseite des Dichtschenkels und die zur Kammer weisende Unterseite der Anlagefläche.

Die Vorrichtung ist zudem mit mindestens einem Ein- und/oder Ausströmrohr für ein Temperiermedium in der Kammer vorgesehen. Das Temperiermedium wird bevorzugt extern vortemperiert und in der gewünschten Temperatur in die Kammer eingeleitet. Um thermische Verluste der Vorrichtung zu vermeiden, ist der Mantel und/oder der Boden der Vorrichtung doppelwandig ausgeführt und thermisch isoliert. Bei einer einwandigen Ausführung der Vorrichtung kann zusätzlich ein aus Halbschalen bestehender Isoliermantel vorgesehen sein, der an der Außenseite der Vorrichtung angeordnet, diese zusätzlich isoliert.

In einer bevorzugten Ausgestaltung mündet ein Einströmrohr für das Temperiermedium am Grund der Kammer, bevorzugt zentral am Grund unterhalb eines in der Kammer angeordneten Gefäßes. Durch das unterhalb des Gefäßes eingebrachte Temperiermedium kann sich dieses gut in der Kammer verteilen und das Gefäß gleichmäßig temperieren.

In einer bevorzugten Ausgestaltung besitzt der Dichtschenkel des Dichtelements eine Keil- oder Trapezform. Die Innenseite des Dichtschenkels ist zur Anlage an das zu temperierende Gefäß vorgesehen. Die Außenseite verläuft geneigt gegenüber der Innenseite. Das Spannelement besitzt eine geneigte Druckfläche, die bevorzugt korrespondierend zu der geneigt verlaufenden Außenseite des Dichtschenkels verläuft. Im montierten Zustand liegt das Spannelement bevorzugt auf dem Anlageschenkel der Dichtung auf und mit seiner Druckfläche an dem Dichtschenkel an. Ein besonderer Vorteil eines Spannelements mit einer geneigt verlaufenden Druckfläche liegt darin, dass die in axialer Richtung auf das Spannelement aufgebrauchte Kraft durch die geneigte Druckfläche in eine radiale Kraft auf den Dichtschenkel umgesetzt wird. Für eine zuverlässige Abdichtung des in der Temperiervorrichtung angeordneten Gefäßes muss auf das Spannelement zum Spannen des Dichtschenkels lediglich eine Kraft in axialer Richtung ausgeübt werden.

In einer bevorzugten Ausgestaltung ist das Spannelement ringförmig ausgebildet und an drei oder mehr Stellen mit der Anlagefläche verbindbar, um die Druckfläche gegen die Außenseite des Dichtschenkels zu pressen.

In einer bevorzugten Ausgestaltung weist das Spannelement auf seiner radial nach innen weisenden Seite mindestens einen Niederhalter auf, der an einem der in der Kammer angeordneten Gefäße anliegt und deren Anheben verhindert.

Bevorzugte Ausgestaltungen der Erfindung werden nachfolgend an Beispielen näher erläutert. Es zeigt:
- Fig. 1: eine Ansicht einer Temperiervorrichtung mit eingesetztem Bubbler,
- Fig. 2: einen Querschnitt der Temperiervorrichtung aus Fig. 1 entlang der Ebene A-A aus Fig. 3
- Fig. 3: eine Draufsicht auf die Temperiervorrichtung aus Fig. 1,
- Fig. 4: eine Vergrößerung des Details B aus Fig. 1,
- Fig. 5: eine Vergrößerung des Details C aus Fig. 1,
- Fig. 6: eine alternative Befestigung des Dichtelements,
- Fig. 7: eine Ansicht einer alternativen Ausgestaltung der Temperiervorrichtung mit eingesetztem Bubbler in einer Ansicht von der Seite,
- Fig. 8: eine Ansicht der Temperiervorrichtung aus Fig. 7 von oben und
- Fig. 9: Detail D aus Fig. 7

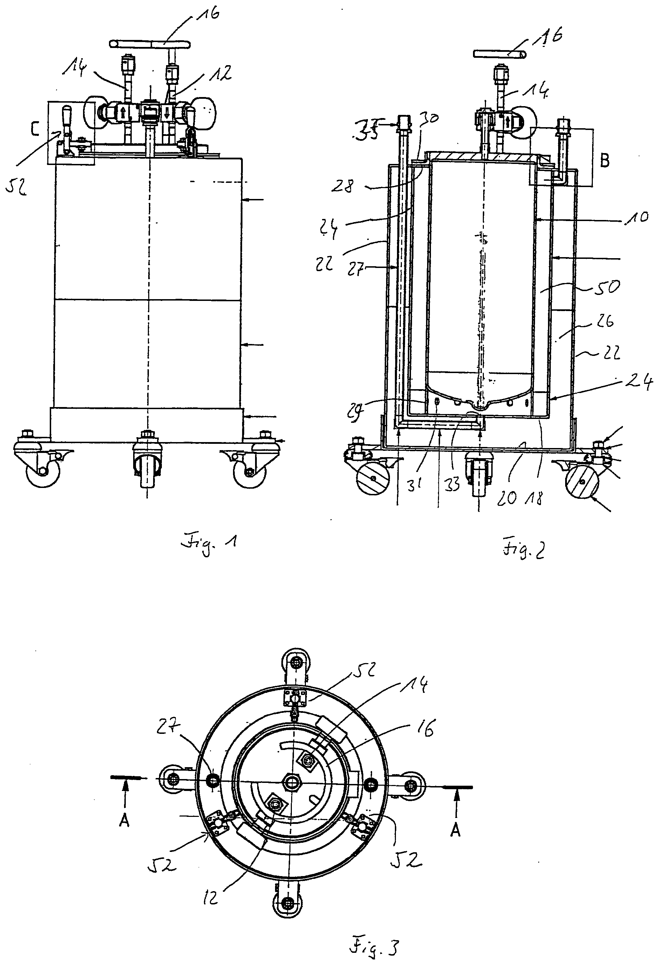

Fig. 2 zeigt in einem Querschnitt einen zylindrischen Bubbler 10 mit seinen Zu- und Ableitungen 12 und 14. Über die Zuleitung 12 wird beispielsweise H₂-Gas in den Bubbler eingeführt, wo es chemisch reagiert und als Dotiergas über die Ableitung 14 wieder austritt. Zur Handhabung besitzt der Bubbler einen zentral angeordneten Griff 16, der als Ringsegment ausgebildet ist. In Fig. 1 ist der Bubbler in die Temperiervorrichtung eingesetzt, so dass die Anschlüsse für die Zu- und Ableitung und der Griff aus der Temperiervorrichtung vorstehen.

Die Temperiervorrichtung ist in dem dargestellten Beispiel doppelwandig ausgeführt, wobei eine innere Bodenwand 18 und eine äußere Bodenwand 20 vorgesehen sind. Die äußere Bodenwand 20 ist mit einer äußeren zylinderförmigen Mantelwand 22 verschweißt. Die innere Bodenwand 18 ist mit einer zylinderförmigen Innenwand 24 verschweißt. Der Innenraum 26 zwischen äußerer und innerer Wand sowie zwischen äußerer und innerer Bodenwand ist mit Isoliermaterial ausgefüllt (nicht dargestellt). Zusätzlich ist ein Zuströmrohr 27 in dem Innenraum 26 angeordnet. Das Zuströmrohr 27 steht an dem oberen Ende 35 aus der Temperiervorrichtung vor und erstreckt sich parallel zu der Mantelwand 22 und der Innenwand 24 bis in den Boden, wo es unter einer 90°-Biegung zentral in die Kammer geführt durch die innere Bodenwand 18 in 33 austritt. Der Bubbler 10 besitzt einen Fuß 29, der aus einer umlaufenden Wand mit radialen Öffnungen 31 besteht. Das im Fußbereich des Bubblers an seinem Ende 33 austretende Temperiermedium verteilt sich innerhalb des Fußes 29 und strömt über die Öffnungen 31 in einen ringzylindrischen Zwischenraum 50, der durch den Bubbler 10 in der Kammer gebildet ist.

Am oberen Ende der Temperiervorrichtung besitzt die äußere Mantelwand 22 einen Flansch 28, der sich radial nach innen bis zu der inneren Mantelwand 24 erstreckt und radial nach innen in die von der inneren Mantelwand gebildete Kammer vorsteht. Der Flansch 28 besitzt auf seiner Oberseite eine Anlagefläche 30, auf der ein im Querschnitt L-förmiges Dichtelement 32 aufliegt.

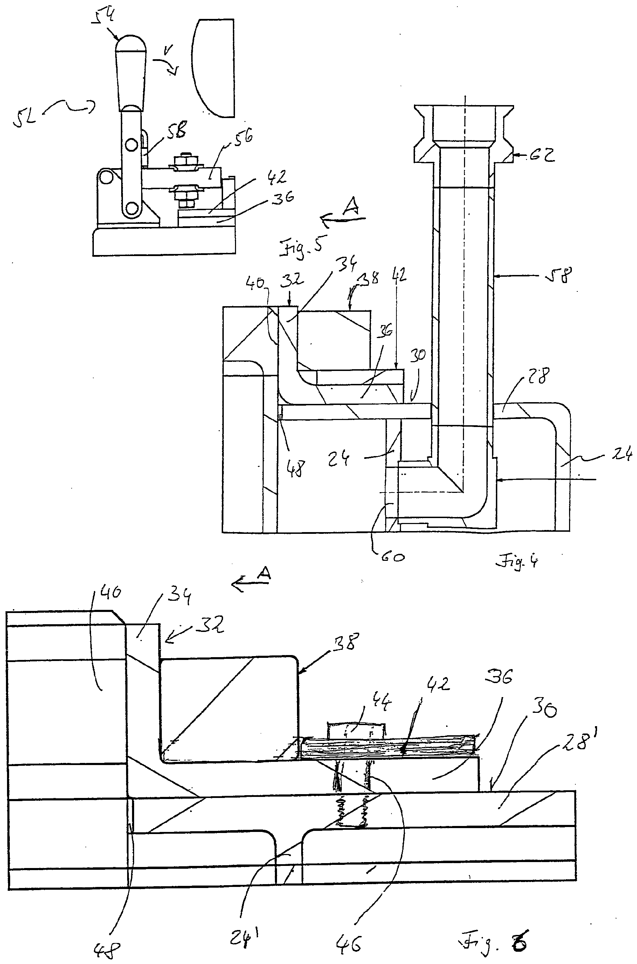

Wie in der Detailansicht B aus Fig. 4 zu erkennen, besitzt das Dichtelement 32 einen vertikal stehenden Dichtschenkel 34 und einen horizontal angeordneten Dichtschenkel 36. Der Dichtschenkel 36 liegt auf der Anlagefläche 30 flach auf. Ein flaches Spannelement 38 liegt an der Außenseite des Dichtschenkels 34 an. Durch ein Betätigen des Spannelements 38 wird dies radial einwärts in Richtung des Pfeils A gespannt, so dass die Innenseite des Dichtschenkels 34 an der Außenfläche des Bubblers 40 dichtend anliegt. In dem dargestellten Ausführungsbeispiel ist von dem Spannelement 38 das Spannschloss gezeigt. Das Spannelement selbst ist als flacher Ring ausgebildet. Zur Fixierung des Anlageschenkels 36 auf der Anlagefläche 30 ist ein umlaufender Ring 42 vorgesehen.

Wie in Fig. 6 dargestellt, kann der Ring 42 über eine Schraube 44 mit dem Flansch 28' verschraubt sein. Die Schraube 44 ist durch eine Bohrung 46 in den Anlageschenkel 36 des Dichtelements 32 geführt und fixiert so das Dichtelement. In dem Beispiel aus Fig. 6 ist der Flansch 28' an der inneren Mantelwand 24' als T-Flansch ausgebildet, der an seinem radial äußeren Ende (nicht dargestellt) mit der äußeren Mantelwand verbunden ist. Alternativ kann die in Fig. 5 vorgesehene Schnellspanneinrichtung 52 vorgesehen sein, die einen Hebel 54 und eine Anpressarm 56 aufweist. Durch ein Verspannen in Richtung V über den Kniehebelmechanismus 58 wird der Ring 42 auf den Anlageschenkel 36 des Dichtelements gepresst.

In den Fign. 4 und 6 ist ein Spalt 48 zwischen der Außenseite des Bubblers 40 und dem Flansch 28, 28' zu erkennen. Der Spalt wird nach oben durch den Anlageschenkel 36 begrenzt. Je nach Abmessung des Bubblers kann der Spalt 48 unterschiedlich groß ausfallen und zugleich effektiv über das Dichtelement 32 abgedichtet werden. Das Temperiermedium tritt über das am oberen Ende der Temperiervorrichtung angeordnete Ausströmrohr 58 aus. Das Ausströmrohr 58 ist über seine Öffnung 60 mit der Kammer verbunden und besitzt an seinem aus der Temperiervorrichtung herausgeführten Ende einen Leitungsadapter 62.

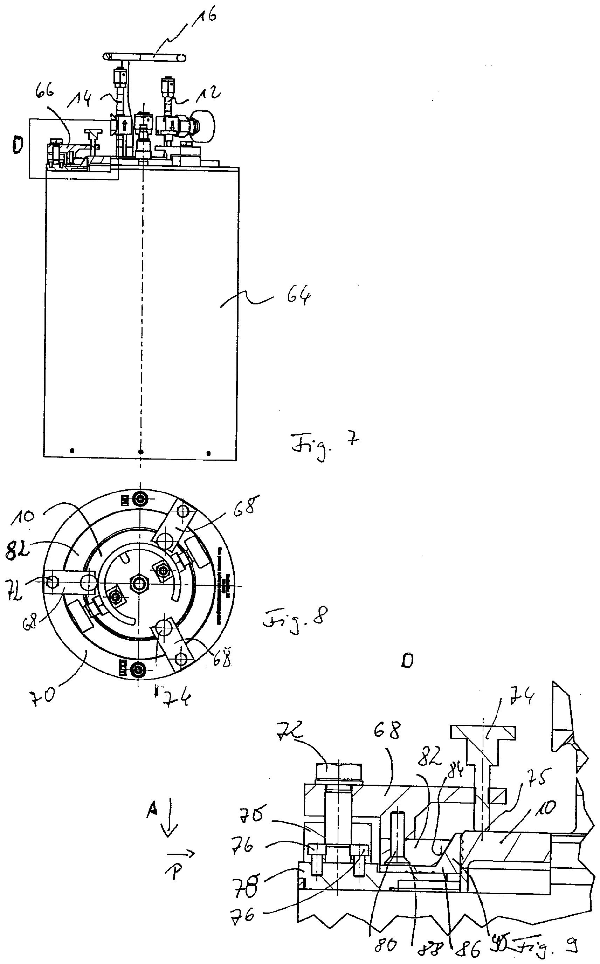

Fig. 7 zeigt eine Temperiervorrichtung 64, in der ein Bubbler 10 mit seinen Zu- und Ableitungen 12 und 14 sowie seinem Griff 16 angeordnet ist. Dem im Schnitt dargestellten Detail D ist ein mit dem Mantel der Temperiervorrichtrung 64 verschraubtes Spannelement 66 dargestellt. Das Spannelement 66 besitzt, wie in der Ansicht aus Fig. 8 zu erkennen, drei Verbindungsbrücken 68, die auf einem umlaufenden Profilrand 70 der Temperiervorrichtung über Bolzen 72 befestigt sind. An dem radial nach innen weisenden Ende der Verbindungsbrücken 68 ist ein Niederhalter 74 vorgesehen, der auf einer Stirnfläche des Bubblers 10 anliegt. Von der Verbindungsbrücke 68 wird ein Spannring 82 gegen die L-förmige Dichtung gepresst.

Fig. 9 zeigt den näheren Aufbau: Ein kreisförmiges Profil 70 ist über Bolzen 76 mit einer oberen Abdeckung 78 der Temperiervorrichtung verschraubt. Ein Befestigungsbolzen 72 ist durch die Verbindungsbrücke 68 geführt und verbindet diese mit dem Profil und der Temperiervorrichtung. Die Verbindungsbrücke 68 ist auf ihrer zur Temperiervorrichtung weisenden Seite über eine Schraub 80 mit dem Spannring 82 verbunden. Der Spannring 82 besitzt an seiner radial nach innen vorstehenden Seite eine schräg verlaufende Druckfläche 84. Der L-förmige Dichtring 86 besitzt einen Anlageschenkel 88 und einen Dichtschenkel 90. Der Dichtschenkel 90 besitzt eine keilförmige Kontur, wobei die Dicke des Dichtschenkels 90 von dem Anlageschenkel 88 aus zu seinem freien Ende hin abnimmt. Der Dichtschenkel 90 liegt auf seiner radial nach innen weisenden Schenkelseite an dem zu temperierenden Bubbler 10 entlang dessen Umfangsfläche an. Durch Anziehen des Bolzens 72 wird eine Kraft in Richtung A über die Verbindungsbrücke 68 auf den Spannring 82 ausgeübt. Über die geneigt verlaufende Druckfläche 84 wird die Kraft in Richtung P radial nach innen umgelenkt, so dass der Dichtschenkel 90 gegen die Umfangswand des Bubblers 10 gepresst wird.

An dem radial nach innen stehenden Ende der Verbindungsbrücke 68 ist der Niederhalter 74 vorgesehen. Der Niederhalter 74 besitzt ein Gewinde, über das seine Position relativ zur Verbindungsbrücke einstellbar ist. Das zu dem Bubbler 10 weisende Ende 70 des Niederhalters 74 liegt, wie in Fig. 9 dargestellt, auf der Oberseite des Bubblers an, so dass dieser sich auch in axialer Richtung nicht bewegen kann. Hierdurch wird der Anpressdruck des Dichtschenkels 90 aufrechterhalten.

Im Betrieb der Temperiervorrichtung wird der Zwischenraum 50 zwischen der Innenwand und dem Gefäß mit einem Temperiermedium, beispielsweise mit Wasser, gespült. Durch die Abdichtung und die Isolierung der Behälterwand kann die Temperatur des Kühlmediums sehr genau eingestellt werden und so der Bubbler insgesamt sehr präzise temperiert werden. Durch den Anpressdruck des Spannelements wird dabei eine Abdichtung erzielt, die auch einen Betrieb mit unter Druck stehendem Kühlmedium gestattet.

## Patentansprüche

1. Vorrichtung (10) zum Temperieren eines Gefäßes in einer Kammer, folgendes aufweisend:
- einen zylindrischen Mantel (22, 24), der die Kammer (26) umschließt,
- einen Boden (18, 20), der an einem Ende des Mantels (22, 24) angeordnet und mit diesem verbunden ist,
- eine Öffnung an einem dem Boden gegenüberliegenden Ende des Mantels, die durch eine parallel zum Boden verlaufende Anlagefläche (30) begrenzt ist,
- ein ringförmiges Dichtelement (32),
- ein ringförmiges Spannelement (38),
**dadurch gekennzeichnet, dass**
das Dichtelement (32) einen L-förmigen Querschnitt mit einem Dichtschenkel (36) und einem Anlageschenkel (34) aufweist, der auf der Anlagefläche (30) aufliegt, wobei das auf das Dichtelement (32) aufgesetzte Spannelement an dem Dichtschenkel auf dessen Außenseite anliegt.

2. Vorrichtung nach Anspruch 1, **dadurch gekennzeichnet, dass** ferner Verbindungsmittel vorgesehen sind, mit denen der Anlageschenkel (34) an der Anlagefläche (30) befestigbar ist.

3. Vorrichtung nach Anspruch 2, **dadurch gekennzeichnet, dass** der Anlageschenkel (34) Bohrungen (46) für die Verbindungsmittel aufweist.

4. Vorrichtung nach Anspruch 2 oder 3, **dadurch gekennzeichnet, dass** die Verbindungsmittel eine Anpressplatte und Schrauben (44) aufweist.

5. Vorrichtung nach Anspruch 2, **dadurch gekennzeichnet, dass** mindestens eine Schnellspanneinrichtung (52) als Verbindungsmittel vorgesehen ist, die in ihrem gespannten Zustand den Anlageschenkel (34) an die Anlagefläche (30) presst.

6. Vorrichtung nach Anspruch 5, **dadurch gekennzeichnet, dass** die Schnellspanneinrichtung (52) einen Kniehebelmechanismus (58) aufweist, der auf der Anlagefläche (30) angebracht ist und über einen Arm den Anlageschenkel (34) gegen die Anlagefläche (30) pressen kann.

7. Vorrichtung nach einem der Ansprüche 1 bis 6, **dadurch gekennzeichnet, dass** Dichtschenkel (36) und Anlageschenkel (34) des Dichtelements (32) im Wesentlichen senkrecht zueinander stehen.

8. Vorrichtung nach einem der Ansprüche 1 bis 7, **dadurch gekennzeichnet, dass** das Dichtelement (32) radial einwärts die Anlagefläche (30) überragt.

9. Vorrichtung nach einem der Ansprüche 1 bis 8, **dadurch gekennzeichnet, dass** mindestens ein Ein- und/oder Ausströmrohr (12, 14) für ein Temperiermedium in der Kammer vorgesehen ist.

10. Vorrichtung nach Anspruch 9, **dadurch gekennzeichnet, dass** das Einströmrohr (27) im Grund der Kammer mündet.

11. Vorrichtung nach einem der Ansprüche 1 bis 10, **dadurch gekennzeichnet, dass** der Mantel (22, 24) und/oder der Boden (18, 20) doppelwandig ausgeführt ist.

12. Vorrichtung nach einem der vorangegangenen Ansprüche, **dadurch gekennzeichnet, dass** der Dichtschenkel (90) eine Keil- oder Trapezform besitzt, bei der die Innenseite des Dichtschenkels (90) zur Anlage an das zu temperierende Gefäß vorgesehen ist und die Außenseite geneigt gegenüber der Innenseite verläuft und das Spannelement eine geneigte Druckfläche aufweist.

13. Vorrichtung nach Anspruch 12, **dadurch gekennzeichnet, dass** das Spannelement in seiner montierten Position auf dem Anlageschenkel (88) aufliegt und mit seiner Druckfläche an dem Dichtschenkel (90) anliegt.

14. Vorrichtung nach Anspruch 12 oder 13, **dadurch gekennzeichnet, dass** das Spannelement ringförmig ausgebildet ist und an drei oder mehr Stellen mit der Anlagefläche verbindbar ist, um die Druckfläche gegen die Außenseite des Dichtschenkels zu pressen.

15. Vorrichtung nach Anspruch 14, **dadurch gekennzeichnet, dass** das Spannelement (74) auf seiner radial nach innen weisenden Seite mindestens einen Niederhalter für ein in der Kammer angeordnetes Gefäß aufweist.

## Claims

1. Device (10) for controlling the temperature of a vessel in a chamber, comprising the following:
- a cylindrical casing (22, 24) enclosing the chamber (26),
- a floor (18, 20) that is located at one end of the casing (22, 24) and is connected to this,
- an opening at one end of the casing opposite the floor, limited by a contact surface (30) running parallel to the floor,
- an annular sealing element (32),
- an annular clamping element (38) **characterised in that** the sealing element (32) has an L-shaped cross section with a sealing leg (36) and a contact leg (34) that lies on the contact surface (30), with the clamping element placed onto the sealing element (32) lying against the outside of the sealing leg.

2. Device according to claim 1, **characterised in that** connecting means are also provided with which the contact leg (34) can be attached to the contact surface (30).

3. Device according to claim 2, **characterised in that** the contact leg (34) features boreholes (46) for the connecting means.

4. Device according to claim 2 or 3, **characterised in that** the connecting means feature a pressure plate and screws (44).

5. Device according to claim 2, **characterised in that** at least one quick-clamping device (52) is provided as a connecting means, which, in its tightened state, presses the contact leg (34) against the contact surface (30).

6. Device according to claim 5, **characterised in that** the quick-clamping device (52) features a toggle mechanism (58) that is mounted on the contact surface (30) and that can press the contact leg (34) against the contact surface (30) via an arm.

7. Device according to one of claims 1 to 6, **characterised in that** the sealing leg (36) and contact leg (34) of the sealing element (32) are substantially perpendicular to each other.

8. Device according to one of claims 1 to 7, **characterised in that** the sealing element (32) protrudes radially inwards beyond the contact surface (30).

9. Device according to one of claims 1 to 8, **characterised in that** at least one inflow and/or outflow pipe (12, 14) is provided for a temperature control medium in the chamber.

10. Device according to claim 9, **characterised in that** the inflow pipe (27) empties into the bottom of the chamber.

11. Device according to one of claims 1 to 10, **characterised in that** the casing (22, 24) and/or the floor (18, 20) is double-walled.

12. Device according to any of the preceding claims, **characterised in that** the sealing leg (90) has a wedge or trapezoidal shape, with the inside of the sealing leg (90) being intended to be placed against the vessel to be temperature-controlled and the outside running on a slope relative to the inside and the clamping element featuring a sloping pressure area.

13. Device according to claim 12, **characterised in that** the clamping element in its mounted position lies on the contact leg (88) and its pressure area lies against the sealing leg (90).

14. Device according to claim 12 or 13, **characterised in that** the clamping element is annular and is connectable to the contact surface at three or more points in order to press the pressure area against the outside of the sealing leg.

15. Device according to claim 14, **characterised in that** the clamping element (74), on its radially inward-facing side, at least one holding-down device for a vessel placed in the chamber.

## Revendications

1. Dispositif (10) assurant la régulation thermique d'un récipient dans une chambre, présentant les éléments suivants :
- un manteau cylindrique (22,24) enveloppant la chambre (26),
- un fond (18, 20), installé à une extrémité du manteau (22, 24) et est relié à ce dernier,
- une ouverture située sur une extrémité du manteau faisant face au fond, et limitée par une surface d'appui (30) parallèle au fond,
- un élément d'étanchéité (32) circulaire,
- un élément de serrage (38) circulaire, **caractérisé en ce que** l'élément d'étanchéité (32) présente une coupe transversale en L avec une branche d'étanchéité (36) et une branche d'appui (34) sur laquelle repose la surface d'appui (30), à savoir que l'élément de serrage placé sur l'élément d'étanchéité (32) repose sur la partie extérieure de la branche d'étanchéité.

2. Dispositif selon la revendication 1, **caractérisé en ce que** des dispositifs de raccord sont prévus afin de permettre une fixation de la branche d'appui (34) à la surface d'appui (30).

3. Dispositif selon la revendication 2, **caractérisé en ce que** la branche d'appui (34) présente des forures (46) pour les éléments de raccord.

4. Dispositif selon la revendication 2 ou 3, **caractérisé en ce que** les éléments de raccord présentent une plaque de pression et des vis (44).

5. Dispositif selon la revendication 2, **caractérisé en ce qu'**au moins un dispositif de serrage rapide (52) est prévu à titre de raccord et qui, lorsqu'il est tendu, presse la branche d'appui (34) contre la surface d'appui (30).

6. Dispositif selon la revendication 5, **caractérisé en ce que** le dispositif de serrage rapide (52) présente un mécanisme à levier articulé (58) installé sur la surface d'appui (30) et peut appuyer la branche d'appui contre la surface d'appui (30) via un levier.

7. Dispositif selon une des revendications 1 à 6, **caractérisé en ce que** la branche d'étanchéité (36) et la branche d'appui (34) de l'élément d'étanchéité (34) font face l'un à l'autre verticalement.

8. Dispositif selon une des revendications 1 à 7, **caractérisé en ce que** l'élément d'étanchéité (32) dépasse transversalement vers l'intérieur au-dessus de la surface d'appui (30).

9. Dispositif selon une des revendications 1 à 8, **caractérisé en ce que** au moins un tuyau d'alimentation et/ou d'évacuation (12,14) soit prévu dans la chambre pour un fluide de régulation thermique.

10. Dispositif selon la revendication 9, **caractérisé en ce que** le tuyau d'alimentation (27) débouche dans le fond de la chambre.

11. Dispositif selon une des revendications 1 à 10, **caractérisé en ce que** le manteau (22, 24) et/ou le fond (18,20) soit équipé d'une double paroi.

12. Dispositif selon une des revendications susmentionnées, **caractérisé en ce que** la branche d'étanchéité (90) ait une forme en coin ou trapézoïdale sur laquelle est prévue la partie intérieure de la branche d'étanchéité (90) allant vers l'installation orientée vers le récipient à tempérer, et la partie extérieure soit inclinée dans la direction de la partie intérieure, et que l'élément de serrage soit doté d'une surface de pression inclinée.

13. Dispositif selon la revendication 12, **caractérisé en ce que** l'élément de serrage, en position montée, repose sur la branche d'appui (88) et repose avec sa surface de pression contre une branche d'étanchéité (90).

14. Dispositif selon la revendication 12 ou 13, **caractérisé en ce que** l'élément de serrage a une forme annulaire est peut être relié à la surface d'appui en trois points ou plus afin de presser la surface de pression contre la partie extérieure de la branche d'étanchéité.

15. Dispositif selon la revendication 14, **caractérisé en ce que** l'élément de serrage (74) est doté, sur sa partie orientée transversalement vers l'intérieur, d'un dispositif de maintien vers le bas pour un récipient situé dans la chambre.
